# EUROPEAN PATENT APPLICATION

(11) **EP 3 179 258 A1**
(43) Date of publication of application: **14.06.2017**
(21) Application number: 16202885.6
(22) Date of filing: 08.12.2016
(51) Int. Cl.: G01R 19/00, G01R 15/18, H02H 3/08

(54) **ELECTRICAL INSTALLATION DEVICE WITH CURRENT SENSING CIRCUIT**

(30) Priority: 10.12.2015 EP 15199384
(71) Applicant: ABB Schweiz AG, 5400 Baden (CH)
(72) Inventor: Hozoi, Adrian, 68219 Mannheim (DE); Marinkovic, Stevan, 5430 Wettingen (CH); Kaul, Holger, 74850 Schefflenz (DE); Wachter, Alexander, 69254 Bammental (DE)
(74) Representative: Marks, Frank

(57) **Abstract**

The invention is about an electrical installation device, comprising electrical contacts (1a, 1b; 2a, 2b; 3a, 3b) operable to connect an electric main circuit ,further comprising at least one current transformer (4, 5, 6) placed with its primary side (4a, 5a, 6a) in series with and coupled to said electrical contacts (1a, 1b, 2a, 2b, 3a, 3b), further comprising a sensing circuit (7) coupled to the secondary side (4b, 5b, 6b) of the current transformer (4, 5, 6), operable to generate a voltage signal representative of the current in the main circuit, further comprising a processing circuit (8) coupled to the sensing circuit (7), operable to initiate a responsive action with respect to the voltage signal representative of the current in the main circuit, the sensing circuit (7) having a shunt resistor (9) and an amplifier circuit (10) connected to the shunt resistor (9) and operable to amplify the voltage drop over the shunt resistor (9) and deliver the voltage drop signal to the processing circuit, the electrical installation device further having a nominal current value adjustment means. The shunt resistor (9) is a fixed value resistor, and the amplifier circuit (10) comprises a variable resistor (11) operable to adjust the amplifier gain, and by adjusting the amplifier gain fulfill the function of the nominal current value adjustment means.

## Description

The invention is about an electrical installation device, operable to connect an electric main circuit, further comprising at least one current transformer coupled with its primary side to the main circuit, further comprising a sensing circuit coupled to the secondary side of the current transformer, operable to generate a voltage signal representative of the current in the main circuit, further comprising a processing circuit coupled to the sensing circuit, operable to initiate a responsive action with respect to the voltage signal representative of the current in the main circuit, the sensing circuit having a shunt resistor and an amplifier circuit connected to the shunt resistor and operable to amplify the voltage drop over the shunt resistor and deliver the amplified voltage drop signal to the processing circuit, the electrical installation device further having a nominal current value adjustment means, according to the preamble of claim 1.

Generally speaking, the invention deals with installation devices providing means to measure the electrical current flowing in a main circuit comprising one or more conductors and means to adjust their response with respect to a desired nominal value of the current. For example, the adjustment allows the user to select a nominal current value within the given operation range of the device. The installation device may be employed for various purposes such as metering, control, monitoring, and protection of electrical equipment or electrical loads. Examples of such installation devices are electronic overload relays, circuit breakers, protective relays, motor starters, motor controllers, etc.

In prior art of installation devices, sensing of the electrical current flowing in the main circuit is achieved by means of one or more current transformers, usually one current transformer for each current path or phase which is led through the installation device.

The secondary terminals or secondary sides of the transformers are connected to an electronic sensing circuit where the secondary current is usually rectified and then converted to a voltage by passing it through a shunt resistor. The shunt voltage is regarded as a signal representative of the current in the main circuit. The voltage signal is typically amplified and further fed to a processing circuit where it is employed to achieve the required functionalities of the installation device. The voltage signal typically features a DC component with a superimposed AC component, the DC component providing information about the magnitude of the current in the main circuit and the AC component providing information about the shape of the waveform. The DC component may be used by the processing circuit to monitor loads or to detect critical conditions such as overloads and short circuits. In installation devices with 3 phases of the main circuit, the AC component of the signal may be employed for example to extract information about possible imbalance of the currents in the phases of the main circuit and help detecting possible fault conditions such as a phase loss.

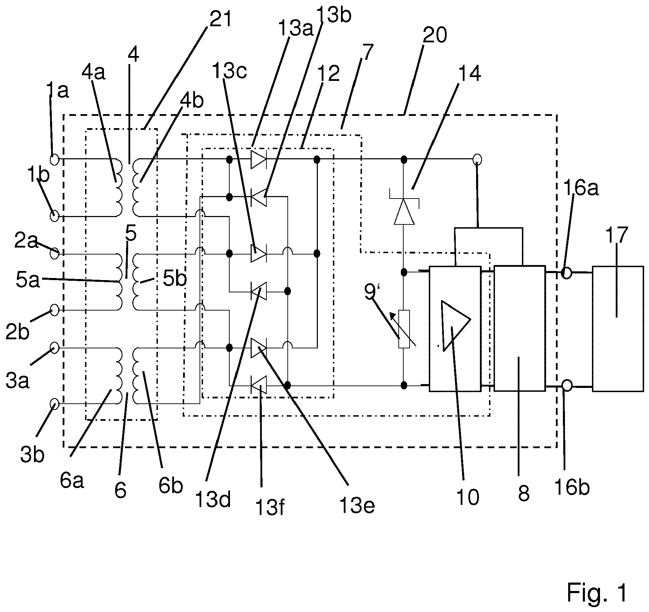

In self-powered installation devices, such as electronic overload relays or circuit breakers, the secondary current of the transformers may also be used to power the electronic circuit. In such cases, a voltage regulator is also provided to power the electronic circuit with a regulated voltage, as shown in Fig 1.

The electronic circuit may be implemented on one or more circuit boards and the circuitry may be based on analog electronic components, however, digital and mixed electronic solutions are increasingly common. The electronic circuitry can be highly integrated into one or more components such as a microcontroller, mixed signal microcontroller, DSP, and/or ASIC.

US 5 657 194 shows a reset circuit for an overload relay. The relay includes current transformers, which are coupled to a full wave rectifier circuit, and a voltage regulating and trip energy storage circuit. A variable resistor or potentiometer in series with a fixed value resistor is used to provide manual overload current range adjustment by converting the rectified current to a corresponding voltage which is further fed to the input of an amplifier being part of time integrator and trip comparator circuit.

US 5 956 221 shows an overload relay employing a custom potentiometer having a resistance that varies at multiple rates to set the trip current value. The custom potentiometer is coupled to a conditioning circuit leading to the input of an amplifier which generate a voltage signal representative of the scaled average current in the main circuit.

In prior art, the shunt resistor is used as well as nominal current value adjustment means. Therefore, in the prior art solutions, the shunt resistor includes a variable resistor such as a potentiometer to allow tuning the response of the system with respect to a desired current value. For doing so, a known electrical installation device provides the user with a knob and a corresponding current scale to adjust the reference or nominal current value. Typically, the knob is mechanically coupled to the variable resistor such as a potentiometer. The term potentiometer is being used here without excluding other types of variable resistors such as trimmer resistors and rheostats. The potentiometer is part of the current shunt and enables delivering a voltage that is proportional to the rectified secondary current and inversely proportional to the nominal current adjusted by the user, as the potentiometer resistance depends on the nominal current setting. Rotary potentiometers are typically employed.

In order to be suitable for current shunt applications, a resistor shall feature low resistance value, good accuracy, good stability under high current load and over the lifetime of the product, and relatively high thermal dissipation capabilities. There are challenges to fulfill all these requirements with a potentiometer and, in present solutions, the accuracy and / or the cost is compromised.

Potentiometers with low resistance value, e.g. less than 100 Ohm, are scarce compared to the ones with higher resistance value, e.g. between 1 k Ohm and 100k Ohm. Furthermore, the potentiometers with low resistance value are also less accurate because they are more sensitive to the error caused by the contact resistance. For example, a contact resistance of 3 Ohm causes an error of 30% to a potentiometer setting of 20 Ohm but only 0.03% to a potentiometer setting of 20k Ohm. The contact resistance has poor stability and varies with manufacturing tolerances but also over climatic conditions like temperature and humidity and over the lifetime of the potentiometer because of aging. Aging effects and drifts are accelerated by the magnitude of the electrical current flowing through the contact and high current values are reached when the potentiometer is used as shunt resistor.

Furthermore, using an adjustable potentiometer as current shunt resistor requires very high input impedance of the circuit reading or amplifying the shunt voltage. If the input impedance of the circuit is not much higher than that of the potentiometer, the sensitivity of the circuit would be influenced by the potentiometer setting resulting in a measurement error varying with the nominal current setting of the installation device.

Thus it is the objective of the present invention to provide an electrical installation device with an improved performance of the nominal current value adjustment means at lower cost.

The objective is achieved by an electrical installation device with the features of claim 1. So according to the invention the shunt resistor is a fixed value resistor, and the amplifier circuit comprises a variable resistor operable to adjust the amplifier gain, and by adjusting the amplifier gain to fulfill the function of the nominal current value adjustment means.

The advantage of the invention is that the shunt function for generating a voltage drop signal representative of the current is separated from the nominal current value adjustment function. This allows in an advantageous way to use a high quality, yet low cost element as a fixed value shunt resistor, and an equally low cost variable resistor with less quality constraints in the gain adjustment part of the amplifier circuit as the nominal current value adjustment means.

A fixed value resistor used as a shunt resistor has the advantage of increased accuracy as compared to potentiometers used for this purpose in the prior art. The fixed value resistor may be fabricated using high accuracy technologies such as thin film, wire wound, or metal foil constructions and it would typically feature passivation and/or sealing in order to guarantee very good stability. Thin film resistors, e.g. where the resistive element consists in a thin metallic layer deposited on a ceramic substrate, feature excellent compromise between accuracy and cost being much more accurate than resistive materials such as cermet or polymer formulations typically used in potentiometers from prior art installation devices. For example, thin film resistors with temperature coefficients of 10 ppm/°C or 25 ppm/°C are widely available at very low cost. A shunt resistor is subject to strong self-heating, that is, its temperature increases with the magnitude of the electrical current flowing through it. Self-heating causes the temperature of the resistive element to vary over wider ranges leading to accuracy errors, which can be minimized if the shunt resistor features low temperature coefficient. The temperature coefficient of potentiometers typically ranges between 100 ppm/°C to 1000 ppm/°C, leading to high self-heating errors. The relatively high current load and self-heating make shunt resistors more prone to aging errors, where their resistance drifts over time. Fixed value resistors are available at low cost with specified load life error less than 0.1% (1000 hrs @ 70°C, loaded). In contrast, the specified load life of typical potentiometers is 3% (without including mechanical wear). Fixed value resistors are thus better suited than potentiometers to handle high current levels as encountered in shunt applications, while ensuring much better accuracy.

The adjustment of the reference or nominal current is according to the invention achieved by providing a gain adjustment means to the amplifier such that the gain of the amplifier is varied by the gain adjustment means. The gain adjustment means comprises a variable resistor, for example a potentiometer, coupled to the input side of the amplifier or being part of the feedback loop of the amplifier, so that the gain of the amplifier can be adjusted by changing the value of the variable resistor.

The solution according to the invention allows reducing the current to be handled by the variable resistor, or potentiometer, resulting in better operation accuracy and in a larger choice of useable potentiometers. The solution also allows employing potentiometers with relatively high resistance value which are easier available and suffer less from errors induced by the contact resistance.

Placing the potentiometer in the feedback loop of the amplifier enables many possible configurations to reach various relationships between the output voltage of the amplifier and the setting of the potentiometer. Additional impedances can be added for further tuning the relationship between the output voltage of the amplifier and the value of the potentiometer and/or for filtering of the signal.

The potentiometer used according to the invention can be any type of variable resistor whose value can be adjusted by the user such as an analog potentiometer, trimmer, rheostat, or digital potentiometer controlled via a physical interface or a programming interface of the installation device. Digital potentiometers typically offer better accuracy, stability, and lifetime than analog potentiometers where the contact is sliding directly on the resistor structure. Common digital potentiometers are programmed via a digital interface.

In a preferred embodiment the electrical installation device comprises electrical contacts operable to connect an electric main circuit, and the current transformer is placed with its primary side in series with and coupled to said electrical contacts.

In a preferred embodiment, the variable resistor is a digital potentiometer adjustable by the position of a knob and featuring high accuracy. Such a potentiometer comprises a series of resistors mounted onto a circuit board that provides a pattern of exposed conductive contacts and means to move a sliding contact on top of the exposed conductive contacts, such that the resistance and/or the ratio of the potentiometer can be manually adjusted. The resistor values and the interconnections are selected to obtain the desired relationship between the position of the sliding contact and the resistance and/or ratio value. Very high accuracy and stability of the potentiometer resistance can be reached as the sliding contact does not rub on the resistive material. Furthermore, the selection of the resistor technology is not constrained and almost any type of resistors can be employed. Small chip resistors may be employed for minimizing the size of the potentiometer. Very good accuracy at moderate cost can be achieved by selecting chip resistors where the resistive elements are made of thin metallic layers, such as in thin film technology.

The shunt resistor is preferably connected in the path of the secondary current delivered by the current transformer(s) such that the full waveform of the secondary current can be measured, in order to avoid losing information about the current waveform. The shunt resistor may thus be placed directly in the path of the secondary current coming from one current transformer or in the path of the rectified current, preferably using a full wave rectifying circuit.

According to an advantageous embodiment, the electrical installation device comprises 3 current transformers and a 3-phase full wave rectifying circuit coupled to the secondary side of the transformers. According to one further advantageous embodiment, the secondary circuits of the 3 current transformers are connected in a delta type configuration and the rectifying circuit comprises six diodes.

The processing circuit may comprise a comparator operable to compare the signal representative of the current in the main circuit with a reference signal, the processing circuit being operable to initiate the responsive action with respect to the re-sult of said comparison. For example, the processing circuit may comprise an integrator and one or more comparators in order to detect fault conditions in the main circuit or in the load connected to the main circuit and to initiate responsive actions such as tripping commands and signaling.

According to an advantageous embodiment, the processing circuit features an analog-to-digital converter and digital processing means which, for example, can be integrated in a microcontroller or other integrated circuit types such as ASIC or DSP. Digital processing allows implementing advanced signal processing and functionalities such as current measurement, current monitoring, thermal overload protection, short-circuit protection, diagnostics, digital communication, etc. According to an advantageous embodiment, the variable resistor is placed in the input branch of the amplifier or is placed in the feedback loop of the amplifier or is placed both in the feedback and in the input branches of the amplifier, so that the gain of the amplifier can be adjusted by changing the value of the variable resistor.

According to an advantageous embodiment, the variable resistor comprises two or more electrical terminals, a sliding electrical contact and one or more resistor elements.

According to an advantageous embodiment, the electrical installation device includes a voltage regulator which is electrically connected in series with the shunt resistor.

According to an advantageous embodiment, the variable resistor comprises two or more discrete resistors mounted onto a circuit board.

According to an advantageous embodiment, the electrical installation device is a protection device such as an electronic overload relay or a circuit breaker, having output terminals operable to connect a tripping unit, wherein the responsive action of the processing circuit is generating a tripping signal and delivering it to the output terminals.

The invention will be described in greater detail by description of five embodiments with reference to the accompanying drawings, wherein
- Figure 1: shows a prior art solution with three current transformers, a three-phase rectifier, a voltage regulator, where the potentiometer is placed in the path of the rectified secondary current acting as current shunt resistor;
- Figure 2: shows an arrangement according to the invention, with a current transformer, a fixed-value shunt resistor, and a variable resistor connected in the feedback loop of an amplifier;
- Figure 3: shows an embodiment according to the invention operating with a 3 phase main circuit and including three current transformers, a three phase rectifier, and a voltage regulator;
- Figure 4: shows an example of connecting the potentiometer in the input branch of the amplifier resulting in a non-linear relationship between the output voltage of the amplifier and the value of the potentiometer;
- Figure 5: shows an example of connecting the potentiometer both in the input and feedback branches of the amplifier;
- Figure 6: shows an example of tuning the relationship between the output voltage of the amplifier and the value of the potentiometer by connecting resistors in series and in parallel to the potentiometer. A capacitor is used for filtering of the signal;
- Figure 7: shows an example of an arrangement allowing high flexibility for tuning the relationship between the output voltage of the amplifier and the value of the potentiometer, wherein a capacitor is used for filtering of the signal;

In the figures, same elements and functional groups or elements and functional groups with same or similar function have the same reference numerals.

Figure 1 shows in an exemplary scheme an electrical installation device 20 according to the prior art, here in the example a three-phase electronic overload relay. It has on its input side three pairs of electrical contacts 1 a, 1 b; 2a, 2b; 3a, 3b operable to connect an electric main circuit. Inside the device 20, there is a three-phase current transformer unit 21, having for each phase a current transformer 4, 5, 6. Each of the transformers 4, 5, 6 is placed with its primary side 4a, 5a, 6a in series with and coupled to the electrical contacts 1 a, 1 b, 2a, 2b, 3a, 3b. Next, there is a sensing circuit 7 coupled to the secondary sides 4b, 5b, 6b of the current transformers 4, 5, 6. The sensing circuit 7 comprises a rectifying circuit 12 coupled to the secondary sides 4b, 5b, 6b of the transformers 4, 5, 6, a variable shunt resistor 9' connected in the path of the rectified current, and an amplifier circuit 15 connected to amplify the voltage drop over the shunt resistor 9'. The rectifying circuit 12 is a 3-phase full wave rectifier comprising six diodes 13a, 13b, 13c, 13d, 13e, 13f. Thus the sensing circuit 7 is operable to generate a voltage signal representative of the current in the main circuit.

Coupled to the sensing circuit 7, there is a processing circuit 8 operable to initiate a responsive action with respect to the voltage signal representative of the current in the main circuit. In the present example the responsive action of the processing circuit 8 is generating a tripping signal and delivering it to the output terminals 16a, 16b operable to connect a tripping unit 17 To this scope, the processing circuit may comprise analog or digital electronics and implement various functionalities such as thermal models, detection of phase imbalance, and self-test. The electrical installation device 20 considered in the example from figure 1 is an electronic overload relay, having output terminals 16a, 16b operable to connect a tripping unit 17, for example a contactor. An electronic overload relay would typically also comprise an auxiliary relay driven by the processing circuit to operate the output terminals 16a, 16b; for simplicity reasons, the said auxiliary relay in not shown in figure 1. Additional output terminals for signaling may also be provided.

The sensing circuit 7 has a variable shunt resistor 9' and an amplifier circuit 15 with an amplifier 10. The amplifier circuit 15 is connected to the variable shunt resistor 9' and is operable to amplify the voltage drop over the variable shunt resistor 9' and to deliver the voltage drop signal to the processing circuit 8.

In the prior art the variable shunt resistor 9' is used as a nominal current value adjustment means. Adjusting the value of the variable resistor allows tuning the response of the system with respect to a rated current value. The variable resistor 9' delivers a voltage drop that is proportional to the rectified secondary current and inversely proportional to the nominal current adjusted by the user. So a high nominal current setting means that the trip signal shall be generated in response to a high current signal only. Consequently the variable shunt resistor 9' is tuned to a low resistor value, so that the voltage drop across it and the voltage input to the amplifying circuit 15 is low, or in other words, the voltage drop needed to trigger the trip signal is achieved at very high current values only. For a low nominal current setting it is vice versa.

For self-powering the electronic circuits in the electronic overload relay 20, there is a voltage regulator 14 provided, fed from the rectifying circuit connected to the secondary side of the transformer unit 21. The voltage regulator 14 is electrically connected in series to the shunt resistance 9'.

As it is difficult to find a variable resistor that fulfills the partly conflicting requirements of high accuracy, low impedance and low cost, the present invention describes an inventive concept of separating the function of shunt resistor for measurement purposes and tuning element for adjusting the nominal current value.

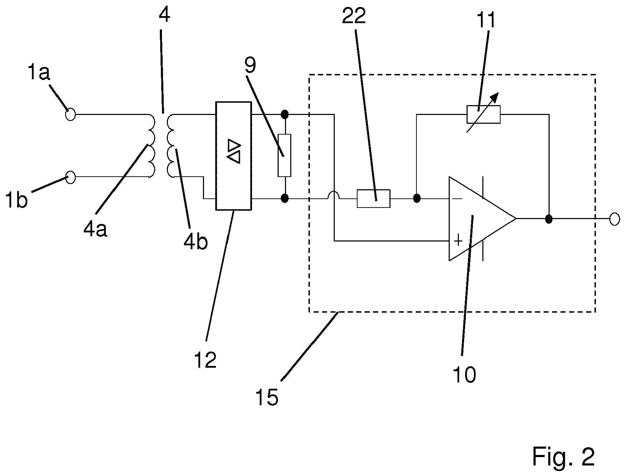

Figure 2 shows the basic concept of the inventive idea in an exemplary and schematic view. Fig. 2 shows exemplarily a single-phase current path, with electrical contacts 1 a, 1 b, current transformer 4 with primary side 4a and secondary side 4b, shunt resistor 9 and amplifier circuit 15 with amplifier 10. A full wave rectifier 12 with diodes is located between the secondary side 4b and the shunt resistor 9.

According to the invention, the shunt resistor 9 is a fixed value resistor, and the amplifier circuit 15 comprises a variable resistor 11 operable to adjust the gain of the amplifier 10, and by adjusting the gain of the amplifier 10 the variable resistor 11 fulfills the function of the nominal current value adjustment means. The variable resistor 11 is here connected in the feedback loop of the amplifier 10 and the fixed value resistor 22 is connected in the input branch of the amplifier 10 providing the gain adjustment means of amplifier 10.

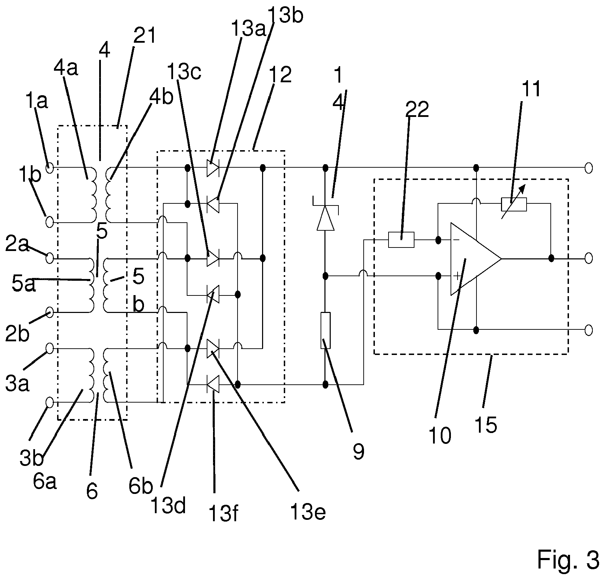

Figure 3 shows the implementation of the inventive concept into a three-phase installation device, analog to the one described in figure 1. The inventive difference is here in figure 3 that the shunt resistor 9 is a fixed value resistor and the detailed setup of the amplifying circuit with a variable resistor 11 in the feedback loop of the amplifier 10, adjusting the gain of the amplifier 10 and by that adjusting the nominal current setting. Advantage is that a highly reliable yet low cost fixed value resistor can be used as shunt resistor 9, and a potentiometer with reduced requirements to accuracy and stability can be used as the nominal current value adjustment means, while providing higher accuracy and lower cost of the arrangement.

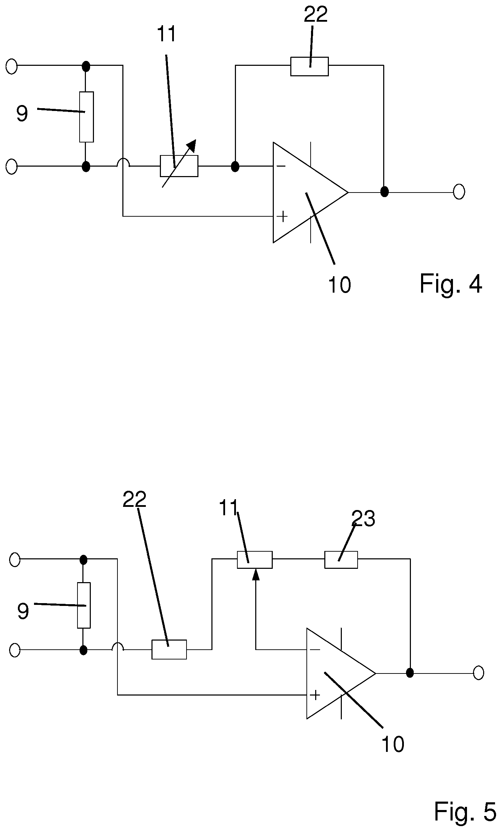

Figure 4 shows another embodiment of the basic inventive concept. Here the variable resistor 11 is connected in the input branch of the amplifier 10, resulting in a non-linear relationship between the output voltage of the amplifier and the value of the potentiometer 11.

Figure 5 shows yet another embodiment of the basic inventive concept. Here the variable resistor 11 is connected both in the input and feedback branches of the amplifier 10. Another fixed value resistors 22 and 23 are connected in series to the variable resistor 11 in the input branch and in the feedback branch, respectively.

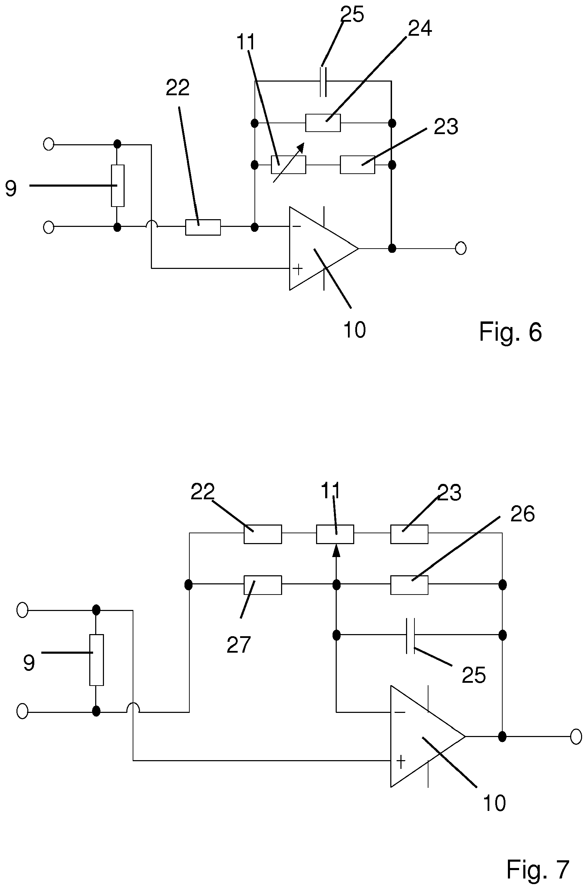

Figure 6 shows yet another embodiment of the basic inventive concept. Here the tuning of the relationship between the output voltage of the amplifier 10 and the value of the potentiometer 11 is achieved by connecting a resistor 23 in series and a resistor 24 in parallel to the potentiometer 11. A capacitor 25 is connected in parallel to the assembly of feedback resistors, potentiometer 11 and fixed resistors 23 and 24, in order to achieve a low-pass filter, used for filtering of the voltage signal delivered by the amplifier 10.

Figure 6 shows yet another embodiment of the basic inventive concept. The arrangement shown in figure 6 allows for high flexibility for tuning the relationship between the output voltage of the amplifier 10 and the value of the potentiometer 11. The variable resistor 11 is connected both in the input and feedback branches of the amplifier 10. A fixed value resistor 23 is connected in series to the variable resistor 11 in the feedback loop, and a fixed resistor 22 is connected in series to the variable resistor 11 in the input branch of the amplifier 10. Another fixed value resistor 26 is connected in parallel to the fixed value resistor 23 in the feedback branch, and another fixed value resistor 27 is connected in parallel to the fixed value resistor 22 in the input branch of the amplifier 10. A capacitor 25 which is connected in parallel to the fixed value resistor 26 in the feedback branch of the amplifier 10 is used for filtering of the signal.

### List of reference signs

- 1 a: electrical contact
- 1b: electrical contact
- 2a: electrical contact
- 2b: electrical contact
- 3a: electrical contact
- 3b: electrical contact
- 4: current transformer
- 4a: primary side
- 4b: secondary side
- 5: current transformer
- 5a: primary side
- 5b: secondary side
- 6: current transformer
- 6a: primary side
- 6b: secondary side
- 7: sensing circuit
- 8: processing circuit
- 9: shunt resistor
- 9': variable shunt resistor
- 10: amplifier
- 11: variable resistor
- 12: rectifying circuit
- 13a: diode
- 13b: diode
- 13c: diode
- 13d: diode
- 13e: diode
- 13f: diode
- 14: voltage regulator
- 15: amplifier circuit
- 16a: output terminal
- 16b: output terminal
- 17: tripping circuit
- 20: electrical installation device
- 21: three-phase current transformer circuit
- 22: fixed value resistor
- 23: fixed value resistor
- 24: fixed value resistor
- 25: capacitor
- 26: fixed value resistor
- 27: fixed value resistor

## Claims

1. An electrical installation device, operable to connect an electric main circuit, further comprising at least one current transformer (4, 5, 6) coupled with its primary side (4a, 5a, 6a) to the main circuit, further comprising a sensing circuit (7) coupled to the secondary side (4b, 5b, 6b) of the current transformer (4, 5, 6), operable to generate a voltage signal representative of the current in the main circuit, further comprising a processing circuit (8) coupled to the sensing circuit (7), operable to initiate a responsive action with respect to the voltage signal representative of the current in the main circuit, the sensing circuit (7) having a shunt resistor (9') and an amplifier circuit (15) with an amplifier (10), said amplifier circuit (15) being connected to the shunt resistor (9') and operable to amplify the voltage drop over the shunt resistor (9') and deliver the amplified voltage drop signal to the processing circuit (8), the electrical installation device further having a nominal current value adjustment means, **characterized in that** the shunt resistor is a fixed value resistor (9), and that the amplifier circuit (15) comprises a variable resistor (11) operable to adjust the gain of the amplifier (10), and by adjusting the gain of the amplifier (10) fulfill the function of the nominal current value adjustment means.

2. Electrical installation device according to claim 1, **characterized in that** the shunt resistor (9) is coupled to the secondary circuit of the one or more current transformer(s) such that the secondary current corresponding to full waveforms is routed through the shunt resistor (9).

3. Electrical installation device according to claim 1 or 2, **characterized in that** it comprises three current transformers (4, 5, 6) and a three-phase full-wave rectifying circuit (12) coupled to the secondary side (4b, 5b, 6b) of the transformer (4, 5, 6), the shunt resistor being connected in the path of the rectified current.

4. Electrical installation device according to claim 3, **characterized in that** the secondary circuits of the three current transformers are connected in a delta type configuration and the rectifying circuit comprises six diodes (13a, 13b, 13c, 13d, 13e, 13f).

5. Electrical installation device according to claim 1 or 2, **characterized in that** the electrical installation device includes a voltage regulator (14) which is electrically connected in series with the shunt resistor (9', 9).

6. Electrical installation device according to claim 1 or 2, **characterized in that** the processing circuit (8) comprises a microcontroller including an analog-to-digital converter.

7. Electrical installation device according to claim 1 or 2, **characterized in that** the electrical installation device is an electronic overload relay or a motor controller or a circuit breaker, having output terminals (16a, 16b) operable to connect a tripping unit (17), wherein the responsive action of the processing circuit (8) is generating a tripping signal and delivering it to the output terminals (16a, 16b).

8. Electrical installation device according to claim 1 or 2, **characterized in that** the processing circuit (8) comprises a comparator operable to compare the signal representative of the current in the main circuit with a reference signal, the processing circuit (8) being operable to initiate the responsive action with respect to the result of said comparison.

9. An electrical installation device according to claim 1, **characterized in that** it comprises electrical contacts (1 a, 1 b; 2a, 2b; 3a, 3b) operable to connect to an electric main circuit, such that the current transformer (4, 5, 6) is connected with its primary side (4a, 5a, 6a) in series with the main circuit.

10. Electrical installation device according to claim 1 or 2, **characterized in that** the variable resistor (11) is placed in the input branch of the amplifier (10) or is placed in the feedback loop of the amplifier (10) or is placed both in the feedback and in the input branches of the amplifier (10), so that the gain of the amplifier (10) can be adjusted by changing the value of the variable resistor (11).

11. Electrical installation device according to claim 1 or 2, **characterized in that** the variable resistor (11) comprises two or more electrical terminals, a sliding electrical contact and one or more resistor elements.

12. Electrical installation device according to claim 1 or 2, **characterized in that** the variable resistor (11) comprises two or more discrete resistors mounted onto a circuit board.

13. Electrical installation device according to claim 1 or 2, **characterized in that** the variable resistor (11) is an analog potentiometer or a trimmer or a rheostat

14. Electrical installation device according to claim 1 or 2, **characterized in that** the variable resistor (11) is a digital potentiometer.
